Europäisches Patentamt

European Patent Office

Office européen des brevets

(19)

(11) Veröffentlichungsnummer : **0 287 578 B1**

(12) ## EUROPÄISCHE PATENTSCHRIFT

(45) Veröffentlichungstag der Patentschrift :
09.08.95 Patentblatt 95/32

(51) Int. Cl.⁶ : **H03M 7/00, G10L 7/06**

(21) Anmeldenummer : **87905587.9**

(22) Anmeldetag : **29.08.87**

(86) Internationale Anmeldenummer :
**PCT/DE87/00384**

(87) Internationale Veröffentlichungsnummer :
**WO 88/01811 10.03.88 Gazette 88/06**

(54) **DIGITALES CODIERVERFAHREN.**

(30) Priorität : **29.08.86 DE 3629434**

(43) Veröffentlichungstag der Anmeldung :
**26.10.88 Patentblatt 88/43**

(45) Bekanntmachung des Hinweises auf die
Patenterteilung :
**09.08.95 Patentblatt 95/32**

(84) Benannte Vertragsstaaten :
**AT BE CH DE FR GB IT LI LU NL SE**

(56) Entgegenhaltungen :
**WO-A-86/03872**
**DE-A- 3 310 480**

(56) Entgegenhaltungen :
**IEEE Transactions on Acoustics, Speech and Signal Processing, Band ASSP-27, Nr.5, Oktober 1979, IEEE, (New York, US), J.M. TRIBO-LET et al.: "Frequency Domain Coding of Speech", seiten 512-530 siehe figuren 8,13,14,18; seite 519, linke Spalte, zeile 6 - rechte Spalte, zeile 28; Seite 522, rechte Spalte, erste bis letzte zeile**
**IBM Technical Disclosure Bulletin, Band 27, Nr. 2, July 1984, (New York, US),W.G. CROUSE et al.: "Adaptive bit Allocation Technique", Seiten 1003-1007 siehe Figur 1; Seite 1003, zeile 1 - Seite 1005, Zeile 8**

(73) Patentinhaber : **BRANDENBURG, Karl-Heinz**
**Am Europakanal 40**
**D-91056 Erlangen (DE)**

(72) Erfinder : **BRANDENBURG, Karl-Heinz**
**Am Europakanal 40**
**D-91056 Erlangen (DE)**

(74) Vertreter : **Münich, Wilhelm, Dr. et al**
**Kanzlei Münich, Steinmann, Schiller**
**Wilhelm-Mayr-Str. 11**
**D-80689 München (DE)**

EP 0 287 578 B1

## Beschreibung

### Technisches Gebiet

Die Erfindung bezieht sich auf ein digitales Codierverfahren für die Übertragung und/oder Speicherung von akustischen Signalen und insbesondere von Musiksignalen.

### Stand der Technik

Ein Standardverfahren zur Codierung akustischer Signale ist die sog. Pulscodemodulation. Bei diesem Verfahren werden Musiksignale mit mindestens 32 kHz, normalerweise mit 44,1 kHz abgetastet. Bei 16 Bit linearer Codierung ergeben sich somit Datenraten zwischen 512 und 705,6 kbit/s.

Verfahren zur Reduktion dieser Datenmengen haben sich für Musiksignale in der Praxis bislang nicht durchsetzen können. Die bisher besten Ergebnisse bei der Codierung und Datenreduktion von Musiksignalen sind mit der sogenannten "Adaptiven Transformationscodierung" erzielt worden; hierzu wird auf die DE-A-33 10 480 verwiesen, auf deren Inhalt im übrigen auch hinsichtlich aller hier nicht näher beschriebenen Einzelheiten ausdrücklich Bezug genommen wird. Die Adaptive Transformationscodierung erlaubt bei guter Qualität Datenreduktionen auf ca 110 kbit/s. Nachteilig bei diesem bekannten Verfahren ist jedoch, daß insbesondere bei kritischen Musikstücken subjektiv wahrnehmbare Qualitätsminderungen auftreten können. Dies kann unter anderem einen Folge davon sein, daß bei dem bekannten Verfahren Störanteile im codierten Signal nicht an die Hörschwelle des Ohres angepaßt werden können und darüberhinaus Übersteuerungen oder zu grobe Quantisierungen möglich sind.

Weitere Verfahren zur Datenreduktion sind aus "IBM Technical Disclosure Bulletin", Vol. 27, No. 2, S. 1003 folg. sowie aus der WO 86/03872 bekannt.

Theoretische Betrachtungen zur Datenreduktion insbesondere von Sprachsignalen sind in dem Artikel "Frequency Domain Coding of Speech", 8084 IEEE Trans. on Acustics, speech & signal proc., Vol. 27, 1979, S. 512 folg. veröffentlicht.

### Darstellung der Erfindung

Der Erfindung liegt die Aufgabe zugrunde, ein digitales Codierverfahren für die Übertragung und/oder Speicherung von akustischen Signalen und insbesondere von Musiksignalen sowie ein entsprechendes Decodierverfahren anzugeben, das ohne subjektive Qualitätsminderung des Musiksignals eine Reduktion der Datenraten um den Faktor 4 bis 6 ermöglicht.

Ein erfindungsgemäße Lösung dieser Aufgabe ist mit ihren Weiterbildungen in den Patentansprüchen gekennzeichnet.

Der Erfindung liegt der Gedanke zugrunde, abweichend vom eingangs gewürdigten Stand der Technik die Spektralkoeffizienten in voneinander getrennten Schritten zunächst zu quantisieren und dann zu codieren.

Zur Realisierung dieses Grundgedankens werden bei dem erfindungsgemäßen Codierverfahren die Daten zunächst blockweise beispielsweise unter Verwendung der "diskreten Cosinus-Transformation", der TDAC-Transformation oder einer "Fast Fourier-Transformation" in einen Satz von Spektralkoeffizienten transformiert (Anspruch 8). Vorher kann eine Pegelsteuerung erfolgen. Ferner ist es möglich, eine sogenannte Fensterung durchzuführen. Aus den Spektralkoeffizienten wird ein Wert für die sog. "spektrale Ungleichverteilung" errechnet. Aus diesem Wert wird dann ein Anfangswert für die Quantisierungsstufe im Spektralbereich bestimmt. Im Gegensatz zu den bekannten Verfahren, wie beispielsweise dem ATC-Verfahren werden sämtliche Daten im Spektralbereich mit der so gebildeten Quantisierungsstufe quantisiert. Das entstehende Feld von ganzen Zahlen, das den quantisierten Werten der Spektralkoeffizienten entspricht, wird mit einem Optimalbzw. Entropiecodierer direkt codiert. Zum Begriff der Entropiecodierung wird beispielsweise auf das Buch "Bildkommunikation" von H. Schönfelder, Springer-Verlag 1983, S. 206 folg. verwiesen.

Wenn die Gesamtlänge der so codierten Daten größer als die für diesen Block zur Verfügung stehende Bitzahl ist, wird die Quantisierungsstufe erhöht und die Codierung erneut durchgeführt. Dieser Vorgang wird so oft wiederholt, bis nicht mehr als die vorgegebene Bitzahl für die Codierung benötigt wird.

Als Zusatzinformation werden gemäß Anspruch 3 in jedem Block übertragen bzw. gespeichert:
- ein Wert für die spektrale Ungleichverteilung,
- ein Auswahlfaktor, der zur Codierung mit den tatsächlich zur Verfügung stehenden Bits benötigt wird,
- die Zahl der zu "Null" quantisierten Spektralkoeffizienten.

Ferner muß der Wert für die aktuelle Signalamplitude (Pegelsteuerung), übertragen werden, sofern eine Pegelsteuerung erfolgt ist. Die Werte dieser Zusatzinformationen können - soweit es sich nicht bereits um ganze Zahlen handelt - grob quantisiert übertragen werden.

Gemäß den Ansprüchen 4 bis 7 können erfindungsgemäß sowohl lineare Quantisierer mit fester oder variabler Quantisierungsstufe als auch nichtlineare, beispielsweise logarithmische oder sog. MAX-Quantisierer verwendet werden. Ferner können auch spezielle Quantisierer verwendet werden, die mit ungerader Stufenzahl arbeiten, so daß die quantisierten Werte entweder genau "0" sind oder sich durch ein Vorzeichenbit und den codierten Wert des Betrages darstellen lassen.

Die Effektivität der Codierung kann für übliche Musiksignale durch zusätzliche Maßnahmen weiter verbessert werden:

Zu hohen Frequenzen hin können Spektralkoeffizienten nach der Quantisierung verschwinden oder sehr klein werden. Diese Werte können gemäß Anspruch 9 bevorzugt gesondert gezählt und codiert werden. In diesem Falle ist dann die Anzahl und die Codierungsart der sehr kleinen Werte gesondert zu übertragen.

Wenn zur Codierung der quantisierten Spektralkoeffizienten eines Blocks nicht alle zur Verfügung stehenden Bits benötigt werden, kann nach Anspruch 11 die Zahl der "übrig gebliebenen" Bits zur Bitzahl des nächsten Blocks mitgezählt werden, d.h. ein Teil der Übertragung erfolgt in dem einen Block, während der restliche Teil erst im nächsten erfolgt. In diesem Falle ist selbstverständlich die Information mit zu übertragen, wieviele Bits bereits zum nächsten Block gehören.

Ferner ist es gemäß Anspruch 11 möglich, die Hörbarkeit von Störungen bei kritischen Musiksignalen dadurch zu vermeiden, daß psychoakustische Erkenntnisse in die Codierung mit einbezogen werden. Diese Möglichkeit ist ein wesentlicher Vorteil des erfindungsgemäßen Verfahrens gegenüber bekannten Verfahren:

Hierzu werden die Spektralkoeffizienten in sog. Frequenzgruppen aufgeteilt. Diese Frequenzgruppen sind so gewählt, daß nach den Erkenntnissen der Psychoakustik eine Hörbarkeit einer Störung ausgeschlossen werden kann, wenn die Signalenergie innerhalb jeder einzelnen Frequenzgruppe deutlich höher als die Störenergie innerhalb der selben Frequenzgruppe oder die Störenergie geringer als die Ruhehörschwelle in dieser Frequenzgruppe ist. Hierzu wird aus den Spektralkoeffizienten nach der Transformation zunächst die Signalenergie für jede Frequenzgruppe errechnet. Hieraus wird errechnet, welche Störenergie für jede Frequenzgruppe zulässig ist. Als zulässiger Wert gilt die Ruhehörschwelle, die u.a. vom eingestellten Wert der Pegelsteuerung abhängig ist, oder die sog. Mithörschwelle, die sich aus der Multiplikation der Signalenergie mit einem von der Frequenz abhängigen Faktor ergibt, je nachdem, welcher Wert größer ist.

Danach werden die Spektralkoeffizienten nach dem vorstehend beschriebenen Verfahren quantisiert, codiert und rekonstruiert. Aus den Orginaldaten der Spektralkoeffizienten und den rekonstruierten Werten kann die Störenergie pro Frequenzgruppe berechnet werden. Wenn die Störenergie in einer Frequenzgruppe größer als die vorher errechnete erlaubte Störenergie in dieser Frequenzgruppe und diesem Block ist, werden die Werte dieser Frequenzgruppe durch Multiplikation mit einem festen Faktor vergrößert, so daß die relative Störung in dieser Frequenzgruppe entsprechend geringer wird. Dann wird wieder quantisiert und codiert. Diese Schritte werden solange iterativ wiederholt, bis entweder die Störung in allen Frequenzgruppen relativ so gering ist, daß eine Hörbarkeit von Störungen ausgeschlossen werden kann oder bis z.B. nach einer bestimmten Zahl von Iterationen zur Verkürzung der Berechnung oder weil keine Verbesserung mehr möglich ist, abgebrochen wird.

Zu beachten ist, daß bei der Codierung mit Berücksichtigung der Hörschwellen die Multiplikationsfaktoren pro Frequenzgruppe als weitere Zusatzinformation mitübertragen werden muß.

Zur Rekonstruktion der Daten (mit und ohne Einbeziehung von psychakustischen Erkenntnissen) müssen gemäß Anspruch 14 zunächst die entorpiecodierten Werte beispielsweise mittels einem Assoziativspeicher in die quantisierten ganzen Zahlen für die Spektralkoeffizienten decodiert werden sowie gegebenenfalls die kleinen Werte und die Werte "=0" ergänzt werden. Anschließend werden die mit dem mit übertragenen Multiplikationsfaktor und einem weiteren, aus dem gegebenenfalls ebenfalls mit übertragenen Wert für die spektrale Ungleichverteilung errechneten Wert multipliziert. Anschließend ist zur Rekonstruktion nur noch eine Rundung erforderlich.

## Beschreibung von Ausführungsbeispielen

Die Erfindung wird nachstehend anhand von zwei Ausführungsbeispielen ohne Beschränkung des allgemeinen Erfindungsgedankens näher beschrieben.

Bei den folgenden Beispielen ist aus Gründen der Übersichtlichkeit M=8; tatsächlich würde jedoch M typischerweise gleich 256, 512 oder 1024 gewählt.

## Beispiel 1

Bei diesem Beispiel wird als Transformation zwischen dem akustischen Signal (Zeitsignal) und den Spektralwerten die Cosinustransformation verwendet. Dabei ist N=M.

Nach der Transformation der N (=M) Abtastwerte des akustischen Signals in den Spektralbereich mit der diskreten Cosinus-Transformation liegen z.B. die folgenden Werte für die Spektralkoeffizienten vor:

-1151    66.4    1860    465    -288    465    -88.6    44.3

Hieraus wird zunächst die spektrale Ungleichverteilung sfm mit der Formel

$$ sfm = \left( \frac{N}{\prod_{i=1}} \sqrt{\delta_i^2} \right)^{\frac{1}{N}} / \sqrt{\frac{1}{N} \sum_{i=1}^{N} \delta_i^2} $$

errechnet. Es ergibt sich:

sfm = 0.0045

Aus sfm wird der quantisierte Wert $sfm_q$ nach folgender Formel errechnet:

$sfm_q = int(ln(1/sfm)/1.8) = 3$

Der mit übertragene Wert $sfm_q$ liegt im Wertebereich 0-15 und ist damit durch 4 Bit darstellbar.

Anschließend erfolgt die 1. Quantisierung im Frequenzbereich, die bei dem gewählten Ausführungsbeispiel ein Teilen des Wertes des jeweiligen Spektralkoeffizienten durch den Wert $q_{anf}$ ist:

$q_{anf} = e^{(1.8 * sfmq)} = 221$

Ferner werden zur Berücksichtigung von psychoakustischen Gegebenheiten die Spektralkoeffizienten in 3 Gruppen eingeteilt:

```
Koeffizienten 1-2              3-4              5-6
              1,32*10^6        3,68*10^6        3,09*10^5
```

und Faktoren für "erlaubte Störungen" eingeführt:

```
0.1                    0.1              0.5  Mithörschwelle
0.05 * letzter Wert    Maskierung von niedrigeren
                       Frequenzen her.
```

Damit ergeben sich als erlaubte Störungen:

$1,32 * 10^5$

$3,68 * 10^5 + 0.05 * 1,32 * 10^6 = 4,34 * 10^5$

$1,54 * 10^5 + 0.05 * 3,68 * 10^6 = 3,38 * 10^5$

Damit sind die für diesen Block konstanten Werte berechnet.

Beim ersten Codierungsversuch mit der Quantisierungsstufe 221 erhält man:

-5,2    0,3    8,4    2,1    -1,3    2,1    -0,4    0,2

bzw. quantisiert:

-5    0    8    2    -1    2    0    0

Bei einer Codierung mit dem folgendem Entropiecoder sollen bei dem gewählten Beispiel 20 Bit zur Verfügung stehen: zu quantisierender

| Wert | Darst. | Länge | | Wert | Darst. | Länge |
|---|---|---|---|---|---|---|
| 0 | 0 | 1 | | 5 | 1111100 | 7 |
| 1 | 100 | 3 | | -5 | 1111101 | 7 |
| -1 | 101 | 3 | | 6 | 11111100 | 8 |
| 2 | 1100 | 4 | | -6 | 11111101 | 8 |
| -2 | 1101 | 4 | | 7 | 111111100 | 9 |
| 3 | 11100 | 5 | | -7 | 111111101 | 9 |
| -3 | 11101 | 5 | | 8 | 1111111100 | 10 |
| 4 | 111100 | 6 | | -8 | 1111111101 | 10 |
| -4 | 111101 | 6 | | | | |

Zur Codierung wird an Bit benötigt:

7    1    10    4    3    4    1    1

Insgesamt werden also 31 Bit zur Codierung benötigt. Die benötigten Bit überschreiten damit den zur Verfügung stehenden Wert. Deshalb erfolgt ein zweiter Quantisierungsversuch.

In der zweiten Quantisierungsstufe, in der bei dem gewählten Beispiel durch die Zahl 2 geteilt und in üblicher Weise gerundet wird, ergeben sich als neue Werte:

-3    0    4    1    -1    1    0    0

zur Codierung werden an Bit benötigt:

5    1    6    3    3    3    1    1

Insgesamt werden also 23 Bit benötigt, so daß eine weitere Quantisierung erforderlich ist, um die (vorgegebene) Darstellungslänge von 20 Bit zu unterschreiten:

In der 3. Quantisierungsstufe wird nochmals durch die Zahl 2 geteilt und gerundet:

-1    0    2    1    0    1    0    0

Zur Codierung dieser Werte werden an Bit benötigt:

3    1    4    3    1    3    1    1

Die benötigte Bitzahl ist 17 und damit kleiner als der vorgegebene Wert, so daß die Codierung bezüglich der Bit-Zahl zum Erfolg geführt hat. Um auch die Brauchbarkeit der Codierung zu überprüfen, wird nunmehr noch die Codierung durch Rekonstruktion der Werte auf der Senderseite überprüft:

Rekonstruktion:

Faktor: $2 * 2 * 221 = 884$

rekonstruierte Werte:

-884    0    1768    884    0    884    0    0

Codierungsfehler pro Koeffizient (Differenz)

267    -66.4    -92    419    288    419    88.6    -44.3

Codierungsfehler pro Frequenzgruppe (je Summe $x^2$)

$7.57 * 10^4$    $1.84 * 10^5$    $2.68 * 10^5$

Der Codierungsfehler ist in jeder Frequenzgruppe kleiner als die erlaubte Störung, so daß die Werte in dieser Stufe tatsächlich codiert und übertragen werden können:

| | | |
|---|---|---|
| Pegelfaktor (Normierung vor der Transformation) | | 4 Bit |
| sfm | 3 | 4 Bit |
| Zahl Mult. für Codierung | 2 | 5 Bit |
| Zahl Mult. äußere Schleife (wenn Störenergie zu groß war) | 0, 0, 0 | 3 * 3 Bit |
| codierte Werte:   10101100100010000 | | 17 Bit (hier) |

Die in der 3. Quantisierungsstufe übertragenen Werte können nun übertragen oder gespeichert werden. Als Zusatzinformation ist, zu übertragen, daß der dritte Codierversuch zum Erfolg geführt hat.

Im folgenden wird die Rekonstruktion der codierten Werte beschrieben:

(i) Rekonstruktion der quantisierten Werte aus den codierten Bitfolgen:

Ergebnis: -1 0 2 1 0 1 0 0

(ii) Division jeder Frequenzgruppe durch den Faktor, sooft wie dies die Zahl der Multiplikationen in der äußeren Schleife angibt:

(Beispiel: 2. Frequenzgruppe 1*) Ergebnis: -1 0 2/3 1/3 0 1 0 0

(iii) Multiplikation mit dem Faktor, sooft wie dies bei der Codierung die Division nötig war:

(im Beispiel 2*, da der angenommene Faktor 2 ist):

Ergebnis: -4 0 8/3 4/3 0 4 0 0

(iv) Aus dem quantisierten Wert von sfm (hier 3) wird wieder die erste Quantisierungsstufe berechnet (hier 221). Mit diesem Wert werden die Koeffizienten multipliziert und gerundet (hier nicht ausgeführt):

Ergebnis: -884 0 589 295 0 884 0 0

Es ergeben sich also andere Werte als am Anfang angegeben, da zusätzlich angenommen wurde, daß die äußere Schleife nochmal durchlaufen wurde, d. h. eine Korrektur (in der zweiten Frequenzgruppe) nötig wurde)

(v) Rücktransformation (Diskrete Cosinus-Transformation, hier nicht ausgeführt)

(vi) Pegelsteuerung Ausgangsteil (wie auch ATC)

(vii) Überlappung mit vorigem Block (Ausgangsteil Fensterung)

## 2. Beispiel

Das im folgenden beschriebene zweite Ausführungsbeispiel weist die zusätzliche Eigenschaft auf, daß sich zur Verringerung des Frequenzübersprechens (Aliasing) die einzelnen Blöcke um die Hälfte der Blocklänge überlappen. Hierzu werden die Abtastwerte des akustischen Signals in einem Eingangspuffer mit einer Fensterfunktion multipliziert (Analysefenster), codiert, auf der Empfängerseite decodiert, erneut mit einer Fensterfunktion multipliziert (Synthesefenster) und die einander überlappenden Bereiche addiert.

Dabei wird bei dem im folgenden beschriebenen Ausführungsbeispiel das Verfahren der "Time Domain Aliasing Cancellation" (TDAC) angewendet, bei dem trotz eines um die Hälfte der Blocklänge überlappenden Fensters die Zahl der im Frequenzbereich zu übertragenden Werte gleich der Zahl der Werte im Zeitbereich ist. Zu Einzelheiten des TDAC-Verfahrens wird beispielsweise auf die Literaturstelle "Subband/Transform Coding Using Filter Bank Designs Based on Time Domain Aliasing Cancellation" in IEEE Proceeding of Intern. Conf. on Acoustic Speech and Signal Proceeding, Jg 1987, S. 2161 f. verwiesen.

Die ersten 8 Abtastwerte des zusammengesetzten Fensters für das akustische Signal werden mit folgenden Werten (Fensterfunktion) multipliziert:

0.1736    .3420    .5    .6428    .7660    .8660    .9397    .9848

Entsprechend werden die zweiten 8 Werte des Fensters mit den "gespiegelten" Werten der Fensterfunktion multipliziert.

Die Abtastwerte des akustischen Signals des letzten Datenblocks können beispielweise folgende Werte sein:

607    541    484    418    337    267    207    154

und die des aktuellen Datenblocks:

108    61    17    -32    -78    -125    -174    -249

Nach der Multiplikation mit der oben angegebenen Fensterfunktion bei einer Überlappung von 8 Werten ergeben sich folgende Werte:

```
105.4    185.0   ·242.0    268.7    258.1    231.2    194.5    151.6
106.3     57.3     14.7    -24.5    -50.1    -62.5    -59.5    -43.2
```

Nach Anwendung des TDAC-Transformations-Algorithmus auf die "gefensterten" 16 Werte erhält man anstelle der 16 Abtastwerte (N=16) des zusammengesetzten Fensters nur noch 8 Spektralwerte (M=8):

43.49    170.56    152.3    -38.0    -31.4    -.59    23.1    6.96

Nunmehr wird der Gleichanteil abgezogen. Bei dem vorliegenden Beispiel ist der quantisierte Gleichanteil =0, da der erste Wert der Frequenzgruppe in der gleichen Größenordnung wie die anderen Werte liegt.

Aus den mit der TDAC-Transformation gewonnenen Spektralwerten wird wieder zunächst die spektrale Ungleichverteilung sfm mit der Formel

$$sfm = \left( \frac{N}{\prod_{i=1}} \sqrt{\delta_i^2} \right)^{\frac{1}{N}} / \sqrt{\frac{1}{N} \sum_{i=1}^{N} \delta_i^2}$$

errechnet. Man erhält:

sfm = 0.2892

Aus sfm wird erneut der quantisierte Wert $sfm_q$ nach folgender Formel errechnet:

$sfm_q = int(\ln(1/sfm)/1.8) = 1$

$q_{amf} = 6.05$

Bei diesem Beispiel soll angenommen werden, daß die erlaubte Bitzahl 25 beträgt.

In der ersten Quantisierungsstufe werden die Spektralwerte durch $q_{anf}=6.05$ geteilt. Man erhält:

7.18        28.20        25.17        -6.28        -5.19        -.097        3.8        1.15

bzw. quantisiert:

7        28        25        -6        -5        0        4        1

Die zur Darstellung dieser Werte mit dem beim ersten Beispiel verwendeten Entropiedecoder benötigte Bitzahl liegt - wie sofort einzusehen ist - über der vorgegebenen Bitzahl; darüberhinaus kommen Werte vor, die den Bereich des Entropiecoders überschreiten. Dies wird als Kriterium verwendet, daß eine weitere Quantisierung erforderlich ist.

Deshalb erfolgt ein zweiter Quantisierungsversuch, bei dem durch 2 ∗ 6.05 geteilt wird. Man erhält:

3.59        14.09        12.59        -3.14        -2.59        -.048        1.90        .575

4        14        13        -3        -3        0        2        1

Auch in dieser Stufe wird die Bitzahl bzw. der Bereich des Entropiecoders überschritten, deshalb erfolgt ein dritter Quantisierungsversuch, bei dem durch 2 ∗ 2∗ 6.05 geteilt wird. Man erhält:

1.79        7.04        6.29        -1.57        -1.29        -.024        .95        .28

2        7        6        -2        -1        0        1        0

Die Bitzahl beträgt nun mit dem im ersten Beispiel angegebenen Entropiecoder:

4        9        8        4        3        1        3        1

Die insgesamt benötigte Bitzahl beträgt 33 und überschreitet damit den vorgegebenen Bereich:

In der vierten Stufe wird durch 2 ∗ 2 ∗ 6.05 geteilt. Man erhält:

.90        3.52        3.14        -.78        -.65        -.012        -.48        .14

1        4        3        -1        -1        0        0        0

Zur Codierung werden folgende Bitzahlen benötigt:

3        6        5        3        3        0        0        0

Die insgesamt benötigte Bitzahl beträgt 23 und liegt damit in dem vorgegebenen Bereich.

Die weitere Vorgehensweise ist analog der in Verbindung mit dem ersten Beispiel beschriebenen.

Zusätzlich soll noch auf folgendes hingewiesen werden:

Wenn an dieser Stelle die Werte, die gleich 0 sind, von hohen Frequenzen her extra gezählt werden (hier 33∗ die 0) und nicht einzeln übertragen werden, dann reichen bereits 20 Bit.

Wie auch bei dem ersten Beispiel erfolgt nun eine Rekonstruktion, um den Quantisierungsfehler zu überprüfen:

Hierzu werden die codierten Werte mit folgendem Faktor:

$$2^3 * 6.05 = 48.397$$

multipliziert. Man erhält folgende rekonstruierte Werte:

| 48.39 | 193.59 | 145.19 | -48.39 | -48.39 | 0 | 0 | 0 |

Codierungsfehler der einzelnen Spektralkoeffizienten beträgt also:

| -4.9 | 23 | -7.11 | 10.39 | 16.99 | -.59 | 23.1 | 6.96 |

Damit erhält man als Fehler pro Frequenzgruppe ($\Sigma x^2$)

$$553 \qquad 158.5 \qquad 289.00$$
$$(1\text{-}2) \qquad (3\text{-}4) \qquad (5\text{-}6)$$

Wie bei dem vorigen Beispiel wird die "erlaubte Störung" berechnet:

$$\text{Energie: Koeff. } 1\text{-}2 \qquad 3\text{-}4 \qquad 5\text{-}6$$
$$30982 \qquad 24639 \qquad 986$$

Die Faktoren für die erlaubten Störungen, die in gleicher Weise wie bei dem vorigen Beispiel berechnet werden, betragen:

$$0.1 \qquad\qquad 0.1 \qquad\qquad 0.5$$
$$+ \qquad 0.05 * \text{letzter Wert} \quad 0,005 * \text{letzter Wert}$$

Hieraus ergibt sich bei diesem Beispiel:

3098.2

$2463.9 + .05 * 3098.2 = 2618.8$

$493 + .05 + 2463.9 = 616.2$

Die erlaubte Störung wurde in keinem Fall überschritten.

Im folgenden soll noch kurz die Rekonstruktion (Decoder) erläutert werden:

(i) Rekonstruktion der quantisierten Werte

Huffman-Decoder: (Beispiel)

Bitstrom:

$$0001 \qquad 0011 \qquad 1001111001110010110100 0xx$$

$$\text{4Bit} \qquad \text{4Bit} \qquad\qquad \text{25 Bit}$$
$$\text{für sfm}_q \quad \text{für Zahl} \qquad \text{für Spektral Koeffizienten}$$
$$=1 \qquad \text{Multiplik.}$$

Der Code ist so gewählt, daß kein Wort Anfangswort eines anderen ist (FANO-Bedingung, aus der Literatur bekannt). Deshalb können die quantisierten Werte aus dem Bitstrom durch Vergleich mit den möglichen Codeworten zurückgewonnen werden:

$$\text{sfm}_q \qquad = \quad 1 \qquad < q_{amf} \quad = 6.05$$
$$\text{Zahl Mult.} \quad = \quad 3 \qquad < \text{quant.Stufe} = 6.05 * 2^3$$
$$= 48.397$$

Die quantisierten Spektralwerte sind:

| 1 | 4 | 3 | -1 | -1 | 0 | 0 | 0 |

Diese Werte werden durch den Korrekturfehler der äußeren Schleife - im Beispiel immer 1 - dividiert und anschließend mit der "Quantisierungsstufe" multipliziert (48.39). Man erhält damit:

48.39　　193.59　　145.19　　-48.49　　-48.39　　0　　0　　0

Nach der Rücktransformation erhält man wieder 16 Werte:

```
-56.42   -11.35   7.20     2.57     -2.57    -7.20    11.35    56.42
 61.45    -2,47-62.24     -73.30    -73.30   -62.24   -2.47    61.45
```

Diese Werte werden mit der selben Fensterfunktion wie bei Sender gefenstert, und man erhält:

```
-9.79    -3.88    3.60     1.65     -1.96    -6.23    10.66    55.5
60.5     -2.3     -53.9    -56.1    -47.1    -31.1    -.05     10.67
```

In einem Zwischenspeicher sind die Ergebniswerte des letzten Durchgangs (letzte 8 Werte) gespeichert.

615.0　　544　　478.6　　411.2　　345.1　　276.3　　198.1　　108.4

Diese Werte werden mit den ersten 8 Werten "überlappt", d.h. die Werte werden addiert. Das Ergebnis, d.h. das Zeitsignal erhält man durch Addition der ersten 8 Werte zu den Werten im Zwischenspeicher:

605.2　　540.1　　475　　409.55　　343.14　　270.07　　208.76　　163.9

Die zweiten 8 Werte werden im Zwischenspeicher gespeichert.

Zum Vergleich sollen die Eingangswerte angegeben werden:

607　　541　　484　　418　　337　　267　　207　　154

Man erkennt sofort die hervorragende Übereinstimmung der Orginaldaten und der rekonstruierten Daten.

Die Erfindung ist vorstehend anhand von Ausführungsbeispielen beschrieben worden, ohne daß hieraus eine Einschränkung des allgemeinen Erfindungsgedankens abgeleitet werden könnte. Selbstverständlich sind die verschiedensten Modifikationen innerhalb dieses allgemeinen Erfindungsgedankens möglich:

Die Quantisierung muß nicht durch eine Division durch einen Wert und nachfolgende Rundung auf einen ganzzahligen Wert erfolgen, selbstverständlich ist auch eine nichtlineare Quantisierung möglich. Diese kann z.B. durch einen Vergleich mit einer Tabelle erfolgen. Nur exemplarisch sollen als Möglichkeitenn die logartihmische und die Max-Quantisierung genannt werden. Auch ist es möglich, zunächst eine Vorverzerrung und anschließend eine lineare Quantisierung durchzuführen.

Ferner ist es möglich, als Optimalcodierer einen Codierer zu verwenden, dessen Ausbildung an die Statisitk der zu übertragenden akustischen Signale angepaßt ist.

Abschließend soll darauf hingewiesen werden, daß typische tatsächliche Werte sehr unterschiedlich von den vorstehend verwendeten Werten sein können. Als Beispiel für tatsächliche Werte seien aufgeführt:

Blocklänge: 512 Werte

Fensterlänge: 32 Werte

Zahl der Frequenzgruppen: 27

Zusatzinformation:

Pegelsteuerung　4 Bit

sfm　4 Bit

Mult.faktor Coder　6 Bit

Mult.fakt. Freq.gr.　27 * 3 Bit

Zahl Werte = 0　9 Bit

Zahl Werte < 1　9 Bit

Mult.faktor Coder 1.189 = sqrt (sqrt(2))

Mult.faktoren Freq.Gruppen 3.

Das erfindungsgemäße Verfahren kann mit einem Signalprozessor realisiert werden. Deshalb kann auf eine detaillierte Beschreibung der schlatungsmäßigen Realisierung verzichtet werden.

## Patentansprüche

1. Digitales Codierverfahren für die Übertragung und/oder Speicherung von akustischen Signalen und insbesondere von Musiksignalen,
   mit folgenden Schritten,
   - N Abtastwerte des akustischen Signals werden in M Spektralkoeffizienten umgesetzt,

- die M Spektralkoeffizienten werden in einer ersten Stufe quantisiert,
- nach Codierung mit einem Entropiecodierer wird die zur Darstellung aller quantisierten Spektralkoeffizienten erforderliche Bitzahl überprüft,
- entspricht die erforderliche Bitzahl nicht einer vorgegebenen Bitzahl, so wird die Quantisierung und Codierung in weiteren Schritten mit geänderter Quantisierungsstufe solange wiederholt, bis die zur Darstellung erforderliche Bitzahl die vorgegebene Bitzahl erreicht,
- zusätzlich zu den Datenbits wird die benötigte Quantisierungsstufe übertragen und/oder gespeichert.

2. Verfahren nach Anspruch 1,
dadurch **gekennzeichnet**, daß aus einer endlichen Zahl zur Verfügung stehender Quantisierungsstufen durch wiederholte Quantisierung mit geänderter Quantisierungsstufe und Codierung mit einem Optimalcodierer und Überprüfung der zur Codierung benötigten Bitzahl die Quantisierungsstufe ausgewählt wird, bei der die Bitzahl im vorgegebenen Bereich liegt.

3. Verfahren nach Anspruch 1 oder 2,
dadurch **gekennzeichnet**, daß zusätzlich Werte für die aktuelle Signalamplitude, die spektrale Ungleichverteilung, den Multiplikationsfaktor für die Codierung im Rahmen der vorgegebenen Bits und/oder die Zahl der "zu Null" quantisierten Spektralkoeffizienten übertragen werden.

4. Verfahren nach einem der Ansprüche 1 bis 3,
dadurch **gekennzeichnet**, daß die Codierung in jeder Stufe nach einer vom Signal abhängigen Zuordnung erfolgt.

5. Verfahren nach einem der Ansprüche 1 bis 4,
dadurch **gekennzeichnet**, daß linear und/oder allgemein nichtlinear quantisiert wird.

6. Verfahren nach einem der Ansprüche 1 bis 5,
dadurch **gekennzeichnet**, daß in der ersten Stufe logarithmisch oder linear und in den weiteren Stufen linear quantisiert wird.

7. Verfahren nach einem der Ansprüche 1 bis 6,
dadurch **gekennzeichnet**, daß ein "Max-Quantisierer" verwendet wird.

8. Verfahren nach einem der Ansprüche 1 bis 7,
dadurch **gekennzeichnet**, daß die Transformation eine diskrete Cosinus-Transformation, eine TDAC-Transformation oder eine Fourier-Transformation ist.

9. Verfahren nach einem der Ansprüche 1 bis 8,
dadurch **gekennzeichnet**, daß Spektralkoeffizienten, die für hohe Frequenzen sehr klein sind oder verschwinden, gesondert gezählt und codiert werden.

10. Verfahren nach einem der Ansprüche 1 bis 9,
dadurch **gekennzeichnet**, daß nicht benötigte Bits eines Blocks auf den nächsten Block übertragen werden.

11. Verfahren nach einem der Ansprüche 1 bis 10,
dadurch **gekennzeichnet**, daß nach den Erkenntnissen der Psychoakustik laufend Schwellen für die Hörbarkeit von Quantisierungsfehlern errechnet und die Spektralwerte so korrigiert werden, daß eine Hörbarkeit von Störungen ausgeschlossen ist.

12. Verfahren nach einem der Ansprüche 1 bis 11,
daadurch **gekennzeichnet**, daß der Gleichanteil (1.Spektralkoeffizient) abgezogen wird.

13. Verfahren nach einem der Ansprüche 1 bis 12,
dadurch **gekennzeichnet**, daß eine Fensterung erfolgt.

14. Verfahren nach einem der Ansprüche 1 bis 13,

**gekennzeichnet** durch folgende Schritte zur Decodierung der akustischen Signale:
- die entropiecodierten Signale werden in die quantisierten ganzen Zahlen für die Spektralkoeffizienten decodiert,
- die kleinen Werte bzw. die Werte "=0" werden gegebenenfalls ergänzt,
- die erhaltenen Werte werden mit gegebenenfalls mit-übertragenen Multiplikationsfaktoren sowie dem Wert für die spektrale Ungleichverteilung multipliziert,
- die Rücktransformation wird ausgeführt,
- gegebenenfalls werden die Werte im Zeitbereich entsprechend der gewählten Fensterung überlappt.

## Claims

1. Digital coding process for transmitting and/or storing acoustic signals, specifically music signals, comprising the following steps:
   - N samples of the acoustic signal are converted into M spectral coefficients;
   - said M spectral coefficients are subjected to quantisation at a first level;
   - after coding by means of an entropic encoder the number of bits required to represent all the quantized spectral coefficients is checked;
   - when the required number of bits does not correspond to a specified number of bits quantization and coding are repeated in subsequent steps, each at a modified quantization level, until the number of bits required for representation reaches the specified number of bits, and
   - additionally to the data bits the required quantization level is transmitted and/or stored.

2. Process according to Claim 1,
   **characterized in** that the quantization level at which the number of bits is within the specified range, is selected among a finite number of quantization levels available by iterative quantization based on a modified quantization level and coding by means of an optimum encoder, and a check of the number of bits required for coding.

3. Process according to Claim 1 or 2,
   **characterized in** that moreover values are transmitted for the actual signal amplitude, the spectral distribution of inequality, the multiplication factor for coding within the scope of the specified bits and/or the number of the quantized spectal coefficients quantized to "zero".

4. Process according to any of Claims 1 to 3,
   **characterized in** that coding is performed at each level in accordance with a relationship depending on the signal.

5. Process according to any of Claims 1 to 4,
   **characterized in** that quantisation is performed in a linear and/or a generally non-linear form.

6. Process according to any of Claims 1 to 5,
   **characterized in** that at the first level quantisation is performed in logarithmic or linear form, and in a linear manner at the subsequent levels.

7. Process according to any of Claims 1 to 6,
   **characterized in** that a "Max" quantizer is employed.

8. Process according to any of Claims 1 to 7,
   **characterized in** that transformation is a discrete cosine transformation, a TDAC transformation, or a Fourier transformation.

9. Process according to any of Claims 1 to 8,
   **characterized in** that spectral coefficients which are very small or which disappear at high frequencies are separately counted and encoded.

10. Process according to any of Claims 1 to 9,
    **characterized in** that bits not required in one block are transferred to the next block.

11. Process according to any of Claims 1 to 10,
**characterized in** that continuously audibility thresholds of quantisation errors are calculated in accordance with the established findings in psychoacoustics, and that the spectral values are corrected so as to preclude the audibility of noise.

12. Process according to any of Claims 1 to 11,
**characterized in** that the equality component (1st spectral coefficient) is subtracted.

13. Process according to any of Claims 1 to 12,
**characterized in** that a window technique is applied.

14. Process according to any of Claims 1 to 13,
**characterized** by the following steps for decoding the acoustic signals:
- the entropically coded signals are decoded into the quantized integer numbers for the spectral coefficients,
- the small values or the values "= 0" are completed if necessary,
- the values so obtained are multiplied by multiplication factors, which are possibly transmitted as well, and by the value of the spectral distribution of inequalities,
- re-transformation is carried out,
- if necessary, the values are overlapped within the time range in correspondence with the selected window technique.


**Revendications**

1. Procédé de codage numérique à transmettre et/ou enregistrer des signaux acoustiques et en particulier des signaux musicaux,
comprenant les opérations suivantes:
- N valeurs échantillonnées du signal acoustique sont converties dans M coefficients spectraux;
- lesdits M coefficients spectraux subissent une quantification à un premier niveau;
- après le codage moyennant un codeur entropique, le nombre de bits requis pour la représentation de tous les coefficients spectraux quantifiés est vérifié,
- quand le nombre de bits requis ne correspond à un nombre de bits déterminé, la quantification et le codage sont répétés dans des opérations ultérieures, chacune à un niveau de quantifications modifiée, jusqu'à ce que le nombre de bits requis pour la représentation atteint le nombre de bits déterminé, et
- supplémentairement aux bits de données, le niveau de quantification requis est transmis et/ou enregistré.

2. Procédé selon la revendication 1,
**caractérisé** en ce que niveau de quantification est choisi, auquel le nombre de bits se trouve au dedans de la gamme déterminée, parmi un nombre fini de niveaux de quantification disponibles, par quantification itérative à niveau de quantification modifié et à codage, moyennant un codeur optimalisant, et à vérification du nombre de bits requis pour le codage.

3. Procédé selon la revendication 1 ou 2,
**caractérisé** en ce que de plus des valeurs sont transmises qui sont relatives à l'amplitude de signal actuelle, à la distribution spectrale d'inégalité, au facteur de multiplication pour le codage dans le cadre de bits déterminés et/ou le nombre de coefficients spectraux quantifiés "à zéro".

4. Procédé selon une quelconque des revendications 1 à 3,
**caractérisé** en ce que le codage set fait à chaque niveau selon une correspondance qui dépend du signal.

5. Procédé selon une quelconque des revendications 1 à 4,
**caractérisé** en ce que la quantification se fait de façon linéaire et/ou non linéaire en général.

6. Procédé selon une quelconque des revendications 1 à 5,
**caractérisé** en ce qu'au premier niveau la quantification se fait de façon logarithmique ou linéaire, et de façon linéaire aux niveaux ultérieurs.

7. Procédé selon une queiconque des revendications 1 à 6,
**caractérisé** en ce qu'on applique un "quantificateur du type MAX".

8. Procédé selon une quelconque des revendications 1 à 7,
**caractérisé** en ce que la transformation est une transformation discrète de cosinus, une transformation TDAC, ou une transformation de Fourier.

9. Procédé selon une quelconque des revendications 1 à 8,
**caractérisé** en ce que des coefficients spectraux, qui sont très petits ou disparaissent à des hautes fréquences, sont comptés et codés à part.

10. Procédé selon une quelconque des revendications 1 à 9,
**caractérisé** en ce que des bits d'un bloc, qui ne sont pas requis, sont transférés au bloc prochain.

11. Procédé selon une queloonque des revendications 1 à 10,
**caractérisé** en ce qu'on calcule, en continu, des seuils d'audition des erreurs de quantification, selon les faits établis de la psycho-acoustique, et corrige les valeurs spectrales à exclure une audibilité de parasites.

12. Procédé selon une quelconque des revendications 1 à 11,
**caractérisé** en ce que le composant d'égalité (premier coefficient spectral) est soustrait.

13. Procédé selon une quelconque des revendications 1 à 12,
**caractérisé** en ce qu'on prévoit une formation de fenêtres.

14. Procédé selon une quelconque des revendications 1 à 13,
**caractérisé** par les étapes suivantes à décoder les signaux acoustiques:
   - les signaux codés à entropie sont décodés dans des nombres entiers quantifiés des coefficients spectraux,
   - les petites valeurs ou les valeurs "= 0" sont éventuellement complétées,
   - les valeurs ainsi obtenues sont multipliées par des facteurs de multiplication éventuellement transmis en même temps, et par la valeur de la distribution spectrale d'inégalité,
   - transformation en retour est réalisée,
   - éventuellement les valeurs sont recouvertes au dedans de la gamme de temps en correspondance avec la technique de fenêtre choisie.